# EUROPEAN PATENT SPECIFICATION

(11) **EP 2 201 768 B1**
(45) Date of publication and mention of the grant of the patent: **11.07.2018**
(21) Application number: 07855414.4
(22) Date of filing: 09.10.2007
(51) Int. Cl.: H04N 7/18, H05K 7/20, H04N 5/225, G08B 13/196

(54) **CAMERA HOUSING HEATSINK BRACKET SYSTEM**
KAMERAGEHÄUSE-KÜHLKÖRPERHALTERUNGSSYSTEM
SYSTÈME DE SUPPORT DE DISSIPATEUR THERMIQUE DE BOÎTIER DE CAMÉRA

(43) Date of publication of application: 30.06.2010
(73) Proprietor: Mayer, Tony, Burnaby, BC V5A 3C2 (CA); Vernon, Mark, Northumberland NE23 1W8 (GB)
(72) Inventor: Mayer, Tony, Burnaby, BC V5A 3C2 (CA); Vernon, Mark, Northumberland NE23 1W8 (GB)
(74) Representative: Bee, Joachim
(86) International application number: PCT/CA2007/001788
(87) International publication number: WO 2009/046513

(56) References cited:
- WO-A2-01/75833
- CA-A1- 2 303 525
- CA-A1- 2 438 939
- US-A- 5 864 365
- US-A1- 2005 022 947
- US-A1- 2005 270 621
- US-A1- 2007 097 652
- US-B1- 6 735 086

## Description

### BACKGROUND

This invention relates generally to the field of camera system housings and to the field of heat-dissipating technologies.

There are many different types of camera system housings including housings designed for a number of different purposes including indoor uses, outdoor stationary use, outdoor mobile use, weather-resistance, bullet proofing, and explosion resistance. Designing camera housings with these types of functionalities can present certain challenges because of the sensitivity of camera equipment including CCDs, filters, lenses, electronic circuitry, and illumination equipment. No matter what the intended use of the camera system, the camera housing must generally provide protection, stability, and heat dissipation to ensure the proper functioning of the camera system.

Cameras and related electronics and illumination devices generate heat, particularly for high-resolution night-time surveillance systems which require high-intensity illumination. This has become a significant constraint on the amount of power that can be packed in to a surveillance system. As a result of this, camera surveillance systems are often large and bulky. This is particularly true for surveillance systems which incorporate more than one camera and for those that use high-powered illuminators.

Other difficulties with existing camera housings include difficulty of manufacturing or assembly. Where many components are involved, they often have to be screwed, bolted, or soldered together. Some components may get in the way of others during the installation or assembly process. The process can thereby become very labor and machine intensive. There may also be difficulty with quality control, as complication in the manufacturing process can result in loosening or damaging the integrity of the camera housing or misalignment of the camera and LEDs. Where camera system components need to be replaced, it is also more difficult to insert and remove them. Internals must often be moved to accommodate lens and camera adjustment.

In addition, complex mounting arrangements can make it difficult to establish proper alignment of the optical components including camera and LEDs difficult during manufacturing and servicing procedures.

### SUMMARY OF THE INVENTION

US 2007/0097652 A1 discloses a heat dissipator assembly for a surveillance camera having a casing and an L-shaped, integrally formed heat dissipator. The heat dissipator assembly includes a surveillance housing system according to the preamble of claim 1. US 5,864,365 B1 discloses a camera housing assembly for protecting a camera from environmental conditions comprising a housing and an internal heat sink received within the housing.

US 6,735,086 B1 discloses a heat-conducting device for conducting heat between a circuit board and an airframe of a missile.

The present invention provides improved heat-dissipation functionality in a simple design that is also easier to manufacture and leads to greater ruggedness, durability, and quality as a final product. It accomplishes these objectives by utilizing fewer components, including a double 'C-bracket' component mounting system for the LEDs and power supply components. The 'C-bracket' which also performs as a heatsink due to its high thermal conductivity and pressure exerted on the inner walls of the camera housing, which is also formed as a heatsink Heat is conducted away from the LEDs, cameras, and electronics circuit boards through a self-locking mechanism that keeps the camera system components in place, properly aligned and ensures easy placement and replacement of those components. The system also provides built in optical alignment of components.

The system comprises two heatsink bracket having components mounted thereon that benefit from heat dissipation, the brackets have flanges that can be compressed for insertion into a heatsink housing and that can be released to press against inner portions of the heatsink housing.

In one preferred embodiment, an illuminator is mounted on a first heatsink bracket and or power supply component is mounted on a second heatsink bracket.The illuminator comprises a bank of LEDs. The LEDs generate considerable heat, which must be dissipated to maintain optimal light output and life of the illuminator. The power supply can also generate considerable heat so it is important that the back bracket has a good thermal path as well.
Further preferred embodiments would include such a system in which:
a) the heatsink bracket comprises a heatsink middle portion on which is mounted a circuit board for components;
b) the first heatsink bracket is slid to an abutment on a wall adjacent to an end of the housing and thereby positions components mounted on the first heatsink bracket at a desired location within the housing;
c) the flanges on the first heatsink bracket are sized such that portions of the flanges adjoining a middle portion of a second heatsink bracket abut end portions of the flanges on the first heatsink bracket when the heatsink brackets are slid to an abutment on a wall adjacent to an end of the housing and thereby position components mounted on the respective heatsink brackets at a desired location within the housing;
c) a housing front frame with illuminator and camera window fits over a camera and an illuminator mounted on a heatsink bracket that has been slid into the housing;
d) the heatsink bracket is a C-bracket with resilient compressible flanges substantially perpendicular to a middle component board portion of the C-bracket;
e) the flanges, when released, abut and exert pressure on inner side walls portions of the housing;
f) flanges on a second heatsink bracket are beveled to fit against a corner angle on a first heatsink bracket for better securing of position and heat transfer;
g) one heatsink bracket is secured to another heatsink bracket with screws which pass through a face portion of one of the heatsink brackets and into a receiving collar on the other heatsink bracket, whereby flanges on one bracket are pulled into contact with a portion of the other bracket;
h) a rear panel seals the housing and secures in position respective heatsink brackets, in order to seal and secure components mounted on the heatsink brackets at a desired location within the housing.

### BRIEF DESCRIPTION OF THE DRAWINGS

Figure 1 is a perspective view of the surveillance housing system before assembly.
Figure 2 is a perspective view of the surveillance housing system with a second heatsink component board bracket's flanges squeezed into the housing.
Figure 3 is a perspective view of the surveillance housing system with a first heatsink component board, on which is mounted an LED illuminator and a camera, having its flanges squeezed into the housing.
Figure 4 is a front perspective view of the first and second heatsink brackets.
Figure 5 is a rear perspective view of the first and second heatsink brackets.
Figure 6 is a perspective view of surveillance housing system, completely assembled.
Figure 7 is a top cross-sectional view of a heatsink bracket with its flanges compressed for insertion into the housing.

### DETAILED DESCRIPTION OF THE DRAWINGS

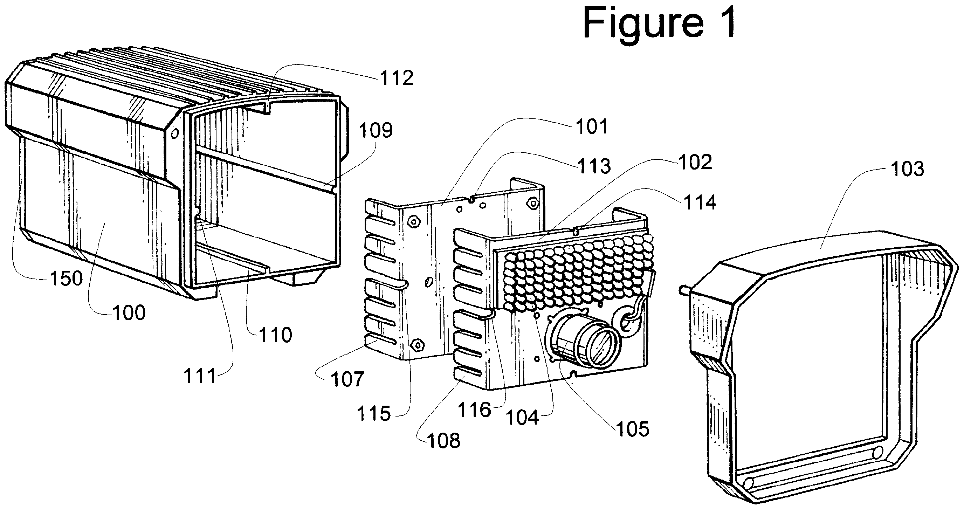

Referring to Figure 1, a perspective view of the surveillance housing system before final assembly is shown comprising camera housing 100, second heatsink component board bracket 101, first heatsink component board bracket 102, and housing front frame 103 The second heatsink component board bracket 101 has flanges 107 on its sides which serve a dual function of providing alignment securing the heatsink bracket 101 into the heatsink camera housing and dissipating heat from the component board bracket 101 which can therefore support a high heat output component power supply or other high heat output components. The first heatsink bracket 102 has similar flanges 108 which dissipate heat from the high powered LED array 104 and the camera 105 as well as any high heat output power supply or camera circuitry on the reverse of the first heatsink component board bracket 102. Both heatsink component board brackets 101 and 102 will fit compactly into the heatsink housing 100 as the flanges 107 and 108 can be squeezed inward to fit inside the camera housing 100. From this view it is apparent that the inside of the heatsink housing 100 is relatively spacious for superior heat dissipation and ease of assembly. Heat is also dissipated from the housing front frame 103 and the housing rear panel 150.

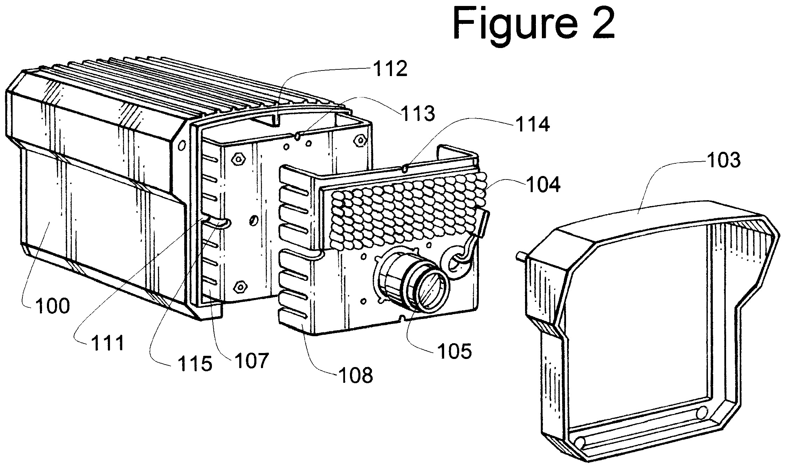

Referring to Figure 2, a perspective view of the surveillance housing system 100 is shown with second heatsink component board bracket 101's flanges 107 squeezed into the heatsink housing 100 with the track 111 of heatsink housing 100 securing heatsink component board bracket 101 via groove 115. Tracks 109, 110, and 112 will also help to secure the heatsink component board brackets 101 and 102 as will the outward pressure from the flanges 107 and 108.

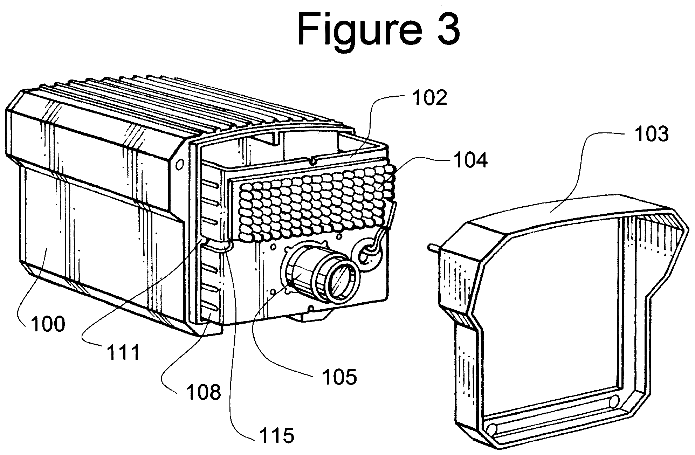

Referring to Figure 3, a perspective view of the surveillance housing system is shown with first heatsink component board bracket 102, on which is mounted an LED illuminator array 104 and a camera 105, having its flanges 108 squeezed into the heatsink housing 100. The system has an efficient design with groove 115 fitting onto the same track 111 as did groove 114 on the second heatsink component board bracket. This allows for more efficient alignment and prevents the C brackets from canting or getting stuck while inserting or removing from the housing.

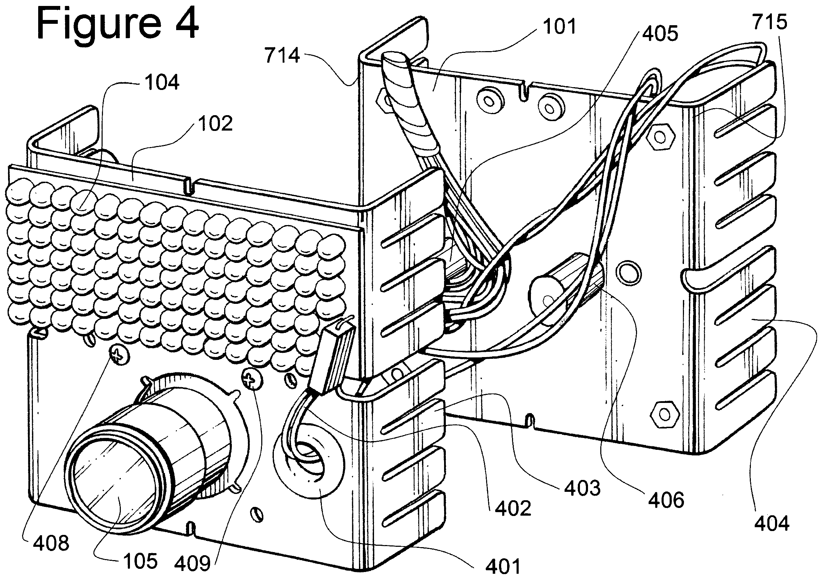

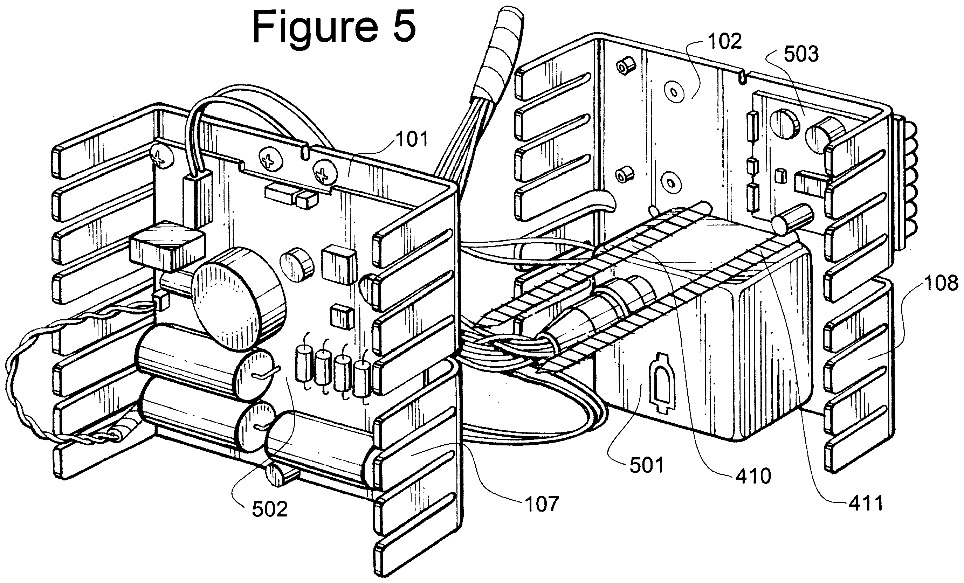

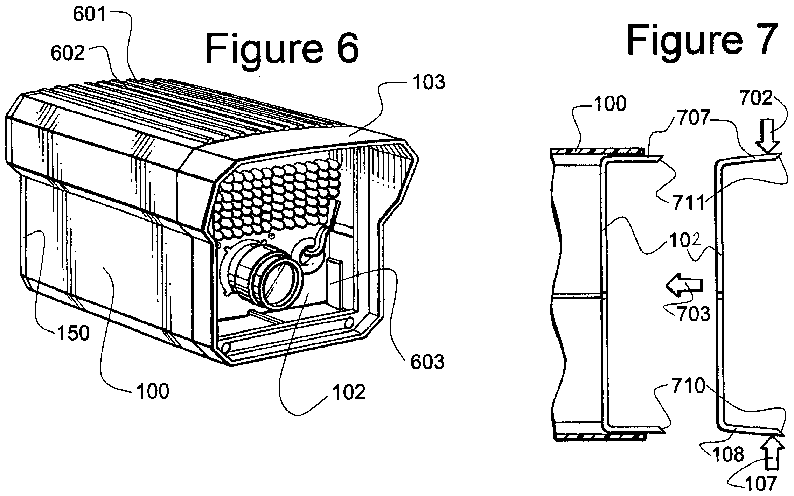

Referring to Figure 4, a front perspective view of the first and second heatsink brackets is shown with heatsink component board bracket's 101 and 102 with the LED illuminator array 104 and the camera 105 affixed to the front of the first heatsink component board bracket 102. There is an opening 401 through which wires 402 connect the LED array to its power supply 502 which is on the reverse of the second heatsink component board bracket 101 The flanges 403 and 404 are shown from another angle and the second heatsink component board bracket 101 is shown from the front to have a bare, heat dissipating face. Optional threaded fastening collars 405 and 406 are affixed to the second heatsink bracket 101, and are adapted to receive optional screws such as 410 and 411 which pass through the first heatsink bracket 102, in order to secure the brackets together and eventually assist in holding the (front) first heatsink bracket 102 when it and the second heatsink bracket 101 are mounted in the housing. The screw head 408 for screw 411 is shown, as is screw head 409 for a like screw (410 in Figure 5) to fit the threaded fastening collar 405. The curvatures 715 and 714 of heatsink bracket 101 are designed to fit tightly against beveled edges 710 and 711 respectively of heatsink bracket 102, illustrated in Figure 7.

Referring to Figure 5, shown is a rear perspective view of the first and second heatsink component board brackets 102 and 101 respectively The reverse of the heatsink component board brackets 101 and 102 is shown with their flanged edges 107 and 108 respectively which are compressed and exert lateral tension when heatsink component board brackets 101 and 102 are respectively mounted inside the camera housing. This lateral tension increases the heatsink capacity of the bracket which is crucial because the LED array 104 is surface mounted to the front of the second heatsink component board bracket and gives off a very significant amount of heat which can interfere with the functioning of the LEDs and even damage them permanently. The second heatsink component board bracket 101 serves to dissipate the tremendous heat given off by the power supply 502 as it converts AC power to DC power; this heat is efficiently dissipated through the heatsink material of the power supply 502 and the flanges 107 on its side. Optional screws 410 and 411 passing through heatsink bracket 102 screw into fastening collars 406 and 405 respectively mounted on heatsink bracket 101 to secure the brackets together within the housing. The securing screws 410 and 411 can thus pull and lock the two C-brackets 101 and 102 together increasing lateral tension for further improved heat transfer to the housing, and locking the two C-brackets together.

Referring to Figure 6, shown is a perspective view of surveillance housing system, completely assembled. The top of the heatsink housing has ridges such as 601 and 602 which serve to increase its surface area thereby dissipating more heat. The top of the unit is the ideal place for such grooves due to the thermodynamic flows which cause heat to rise. Heatsink bracket 102 can be inserted in the housing from the rear and positioned in place by by abutments such as 603 on an inner wall of the housing 100. Alternatively, depending on the desired position for components on the heatsink bracket 102 may be positioned by abutment with the housing front frame 103, as heatsink bracket 101 (shown in figures 1-5) or secured by abutment with the housing rear panel 150.

Referring to Figure 7, shown is a top cross-sectional view of a heatsink bracket with its flanges compressed for insertion into the housing. This is a sequence diagram beginning on the right with heatsink component board bracket 102 then being placed into the housing 100. As this happens flanges 107 and 707 are pressed inward at 701 and 702 respectively so that they can slide in the direction of 703 into the housing 100. Inside the housing, the flanges 108 and 707 are compressed, exerting pressure on the housing 100 which helps to secure them in place and dissipate heat more efficiently. The beveled edges 710 and 711 of the flanges i.e. 707 on heatsink bracket 102 are designed to ensure a tighter fit against heatsink bracket 101 (shown in figure 4, at 715 and 714 respectively).

## Claims

1. A surveillance housing system comprising two heatsink brackets (101, 102) having components mounted thereon that benefit from heat dissipation, the heatsink brackets (101, 102) having flanges that can be compressed for insertion into a heatsink housing (100) and that can be released to press against inner portions of the heatsink housing (100), in which one of the two heatsink brackets (101, 102) is slid to an abutment on a wall of the heatsink housing (100) and thereby positions the components mounted on said heatsink bracket (101, 102) at a desired location within the heatsink housing (100), **characterized in that** the heatsink brackets (101, 102) are C-bracket with the resilient compressible flanges perpendicular to a middle component board portion of the C-bracket, **in that** an illuminator is mounted on a first heatsink bracket (102) as one of the two heatsink brackets (101, 102), and **in that** a power supply component is mounted on a second heatsink bracket (101) as another one of the two heatsink brackets (101, 102).

2. The surveillance housing system of Claim 1, in which a camera (105) and the illuminator are mounted on the first heatsink bracket (102), to provide easy and positive optical alignment.

3. The surveillance housing system of Claim 2, in which the flanges on the first heatsink bracket (102) are sized such that portion of the flanges adjoining a middle portion of the second heatsink bracket (101) abut end portions of the flanges on the first heatsink bracket (102) when the heatsink brackets (101, 102) are slid to an abutment on a wall adjacent to an end of the heatsink housing (100) and thereby position components mounted on the respective heatsink brackets (101, 102) at a desired location within the heatsink housing (100).

4. The surveillance housing system of Claim 3, in which a housing front frame with illuminator and camera window fits over the camera (105) and the illuminator mounted on the first heatsink bracket (102) that has been slid into the heatsink housing (100).

5. The surveillance housing system of Claim 1, in which the flanges, when released, abut and exert pressure on inner side walls portions of the heatsink housing (100).

6. The surveillance housing system of Claim 1, in which flanges on the second heatsink bracket (101) are beveled to fit against a corner angle on the first heatsink bracket (102) for better securing of position and heat transfer.

7. The surveillance housing system of Claim 1, in which one heatsink bracket (101, 102) is secured to another heatsink bracket (101, 102) with screws which pass through a face portion of one of the heatsink brackets (101, 102) and into a receiving collar on the other heatsink bracket (101, 102), whereby flanges on one heatsink bracket (101, 102) are pulled into contact with a portion of the other heatsink bracket (101, 102) in order to increase lateral tension for further improved heat transfer to the heatsink housing (100), in addition to locking the heatsink brackets (101, 102) together.

8. The surveillance housing system of Claim 1, in which complementary grooves and tracks respectively on the heatsink brackets (101, 102) and walls of the heatsink housing (100) provide for efficient alignment of the heatsink brackets (101, 102) within the heatsink housing (100), preventing them from canting or getting stuck during insertion or removal from the heatsink housing (100).

9. The surveillance housing system of Claim 1, in which a rear panel seals the heatsink housing (100) and secures in position respective heatsink brackets (101, 102), in order to seal and secure components mounted on the heatsink brackets (101, 102) at a desired location within the heatsink housing (100).

10. The surveillance housing system of Claim 1, in which:
a) the heatsink bracket (101, 102) comprises a heatsink middle portion on which is mounted a circuit board for components;
b) the first heatsink bracket (102) is slid to an abutment on a wall adjacent to an end of the heatsink housing (100) and thereby positions components mounted on the first heatsink bracket (102) at a desired location within the heatsink housing (100);
c) the flanges on the first heatsink bracket (102) are sized such that portion of the flanges adjoining a middle portion of the second heatsink bracket (101) abut end portions of the flanges on the first heatsink bracket (102) when the heatsink brackets (101, 102) are slid to an abutment on a wall adjacent to an end of the heatsink housing (100) and thereby position components mounted on the respective heatsink brackets (101, 102) at a desired location within the heatsink housing (100);
d) a housing front frame with illuminator and camera window fits over a camera (105) and the illuminator mounted on the first heatsink bracket (102) that has been slid into the heatsink housing (100);
e) the flanges, when released, abut and exert pressure on inner side walls portions of the heatsink housing (100);
f) a top of the heatsink housing (100) has ridges for increased surface area to dissipate more heat from the inside the heatsink housing (100).

11. The surveillance housing system of Claim 1, in which:
a) flanges on the second heatsink bracket (101) are beveled to fit against a corner angle on the first heatsink bracket (102) for better securing of position and heat transfer;
b) one heatsink bracket (101, 102) is secured to another heatsink bracket (101, 102) with screws which pass through a face portion of one of the heatsink brackets (101, 102) and into a receiving collar on the other heatsink bracket (101, 102), whereby flanges on one heatsink bracket (101, 102) are pulled into contact with a portion of the other heatsink bracket (101, 102) in order to increase lateral tension for further improved heat transfer to the heatsink housing (100), in addition to locking the heatsink brackets (101, 102) together;
c) complementary grooves and tracks respectively on the heatsink brackets (101, 102) and walls of the heatsink housing (100) provide for efficient alignment of the heatsink brackets (101, 102) within the heatsink housing (100), preventing them from canting or getting stuck during insertion or removal from the heatsink housing (100).

12. The surveillance housing system of Claim 10, in which:
a) flanges on the second heatsink bracket (101) are beveled to fit against a corner angle on the first heatsink bracket (102) for better securing of position and heat transfer;
b) one heatsink bracket (101, 102) is secured to another heatsink bracket (101, 102) with screws which pass through a face portion of one of the heatsink brackets (101, 102) and into a receiving collar on the other heatsink bracket (101, 102), whereby flanges on one heatsink bracket (101, 102) are pulled into contact with a portion of the other heatsink bracket (101, 102) in order to increase lateral tension for further improved heat transfer to the heatsink housing (100), in addition to locking the heatsink brackets (101, 102) together;
c) complementary grooves and tracks respectively on the heatsink brackets (101, 102) and walls of the heatsink housing (100) provide for efficient alignment of the heatsink brackets (101, 102) within the heatsink housing (100), preventing them from canting or getting stuck during insertion or removal from the heatsink housing (100);
d) a rear panel seals the heatsink housing (100) and secures in position respective heatsink brackets (101, 102), in order to seal and secure components mounted on the heatsink brackets (101, 102) at a desired location within the heatsink housing (100).

## Patentansprüche

1. Überwachungsgehäusesystem, umfassend zwei Kühlkörperhalterungen (101, 102) mit darauf montierten Komponenten, die von Wärmeableitung profitieren, wobei die Kühlkörperhalterungen (101, 102) Flansche aufweisen, die zum Einsetzen in ein Kühlkörpergehäuse (100) komprimiert werden können, und die losgelassen werden können, um gegen Innenabschnitte des Kühlkörpergehäuses (100) zu drücken, wobei
eine der beiden Kühlkörperhalterungen (101, 102) an ein Widerlager auf einer Wand des Kühlkörpergehäuses (100) gleiten gelassen wird und dadurch die an der Kühlkörperhalterung (101, 102) montierten Komponenten an einem gewünschten Ort innerhalb des Kühlkörpergehäuses (100) positioniert werden, **dadurch gekennzeichnet, dass** die Kühlkörperhalterungen (101, 102) C-Halterungen sind, bei denen die federnden komprimierbaren Flansche rechtwinklig zu einem Mittelkomponentenplattenabschnitt der C-Halterung sind, dass ein Beleuchtungsgerät an einer ersten Kühlkörperhalterung (102) als eine der beiden Kühlkörperhalterungen (101, 102) montiert ist, und dass eine Stromversorgungskomponente an einer zweiten Kühlkörperhalterung (101) als eine weitere der beiden Kühlkörperhalterungen (101, 102) montiert ist.

2. Überwachungsgehäusesystem nach Anspruch 1, wobei eine Kamera (105) und das Beleuchtungsgerät an der ersten Kühlkörperhalterung (102) montiert sind, um einfache und positive optische Ausrichtung bereitzustellen.

3. Überwachungsgehäusesystem nach Anspruch 2, wobei die Flansche an der ersten Kühlkörperhalterung (102) so bemessen sind, dass der Abschnitt der Flansche, der an einen Mittelabschnitt der zweiten Kühlkörperhalterung (101) grenzt, an Endabschnitte der Flansche an der ersten Kühlkörperhalterung (102) stößt, wenn die Kühlkörperhalterungen (101, 102) an ein Widerlager auf einer Wand neben einem Ende des Kühlkörpergehäuses (100) gleiten gelassen werden und dadurch Komponenten, die auf der jeweiligen Kühlkörperhalterung (101, 102) montiert sind, an einem gewünschten Ort innerhalb des Kühlkörpergehäuses (100) positioniert werden.

4. Überwachungsgehäusesystem nach Anspruch 3, wobei ein Gehäusevorderrahmen mit Beleuchtungsgerät und Kamerafenster über die Kamera (105) passt und das Beleuchtungsgerät auf der ersten Kühlkörperhalterung (102) montiert ist, die in das Kühlkörpergehäuse (100) gleiten gelassen wurde.

5. Überwachungsgehäusesystem nach Anspruch 1, wobei die Flansche, wenn sie losgelassen werden, an die inneren Seitenwandabschnitte des Kühlkörpergehäuses (100) stoßen und Druck darauf ausüben.

6. Überwachungsgehäusesystem nach Anspruch 1, wobei Flansche auf der zweiten Kühlkörperhalterung (101) angeschrägt sind, um gegen einen Eckwinkel an der ersten Kühlkörperhalterung (102) zu passen, um besser in Position gesichert werden und besser Wärme übertragen zu können.

7. Überwachungsgehäusesystem nach Anspruch 1, wobei eine Kühlkörperhalterung (101, 102) an einer anderen Kühlkörperhalterung (101, 102) mit Schrauben gesichert ist, die eine Seitenfläche von einer der Kühlkörperhalterungen (101, 102) durchlaufen und in ein Aufnahmemanschette auf der anderen Kühlkörperhalterung (101, 102) gelangen, wodurch Flansche auf einer Kühlkörperhalterung (101, 102) in Kontakt mit einem Abschnitt der anderen Kühlkörperhalterung (101, 102) gezogen werden, um die laterale Spannung für weiter verbesserte Wärmeübertragung an das Kühlkörpergehäuse (100) zu erhöhen sowie außerdem die Kühlkörperhalterungen (101, 102) miteinander zu verriegeln.

8. Überwachungsgehäusesystem nach Anspruch 1, wobei komplementäre Rillen beziehungsweise Schienen auf den Kühlkörperhalterungen (101, 102) und Wänden des Kühlkörpergehäuses (100) effiziente Ausrichtung der Kühlkörperhalterungen (101, 102) innerhalb des Kühlkörpergehäuses (100) bereitstellen, wodurch diese am Verkanten oder Steckenbleiben während des Einführens oder Entfernens aus dem Kühlkörpergehäuse (100) gehindert werden.

9. Überwachungsgehäusesystem nach Anspruch 1, wobei eine hintere Platte das Kühlkörpergehäuse (100) versiegelt und jeweilige Kühlkörperhalterungen (101, 102) in Position sichert, um Komponenten die auf den Kühlkörperhalterungen (101, 102) montiert sind, an einem gewünschten Ort innerhalb des Kühlkörpergehäuses (100) zu versiegeln und zu sichern.

10. Überwachungsgehäusesystem nach Anspruch 1, wobei:
a) die Kühlkörperhalterung (101, 102) einen Kühlkörpermittelabschnitt umfasst, auf dem eine Schaltplatine für Komponenten montiert ist;
b) die erste Kühlkörperhalterung (102) an ein Widerlager auf einer Wand neben einem Ende des Kühlkörpergehäuses (100) gleiten gelassen wird und dadurch Komponenten, die auf der ersten Kühlkörperhalterung (102) positioniert sind, an einem gewünschten Ort innerhalb des Kühlkörpergehäuses (100) positioniert werden;
c) die Flansche an der ersten Kühlkörperhalterung (102) so bemessen sind, dass der Abschnitt der Flansche, der an einen Mittelabschnitt der zweiten Kühlkörperhalterung (101) grenzt, an Endabschnitte der Flansche an der ersten Kühlkörperhalterung (102) stößt, wenn die Kühlkörperhalterungen (101, 102) an ein Widerlager auf einer Wand neben einem Ende des Kühlkörpergehäuses (100) gleiten gelassen werden und dadurch Komponenten, die auf der jeweiligen Kühlkörperhalterung (101, 102) montiert sind, an einem gewünschten Ort innerhalb des Kühlkörpergehäuses (100) positioniert werden;
d) ein Gehäusevorderrahmen mit Beleuchtungsgerät und Kamerafenster über eine Kamera (105) passt und das Beleuchtungsgerät auf der ersten Kühlkörperhalterung (102) montiert ist, die in das Kühlkörpergehäuse (100) gleiten gelassen wurde;
e) die Flansche, wenn sie losgelassen werden, an die inneren Seitenwandabschnitte des Kühlkörpergehäuses (100) stoßen und Druck darauf ausüben;
f) ein oberer Bereich des Kühlkörpergehäuses (100) Kämme für vermehrte Oberfläche aufweist, um mehr Wärme aus dem Inneren des Kühlkörpergehäuses (100) abzuleiten.

11. Überwachungsgehäusesystem nach Anspruch 1, wobei:
a) Flansche auf der zweiten Kühlkörperhalterung (101) angeschrägt sind, um gegen einen Eckwinkel an der ersten Kühlkörperhalterung (102) zu passen, um besser in Position gesichert zu werden und besser Wärme übertragen zu können;
b) eine Kühlkörperhalterung (101, 102) an einer anderen Kühlkörperhalterung (101, 102) mit Schrauben gesichert ist, die eine Seitenfläche von einer der Kühlkörperhalterungen (101, 102) durchlaufen und in ein Aufnahmemanschette auf der anderen Kühlkörperhalterung (101, 102) gelangen, wodurch Flansche auf einer Kühlkörperhalterung (101, 102) in Kontakt mit einem Abschnitt der anderen Kühlkörperhalterung (101, 102) gezogen werden, um die laterale Spannung für weiter verbesserte Wärmeübertragung an das Kühlkörpergehäuse (100) zu erhöhen sowie außerdem die Kühlkörperhalterungen (101, 102) miteinander zu verriegeln;
c) komplementäre Rillen beziehungsweise Schienen auf den Kühlkörperhalterungen (101, 102) und Wänden des Kühlkörpergehäuses (100) effiziente Ausrichtung der Kühlkörperhalterungen (101, 102) innerhalb des Kühlkörpergehäuses (100) bereitstellen, wodurch diese am Verkanten oder Steckenbleiben während des Einführens oder Entfernens aus dem Kühlkörpergehäuse (100) gehindert werden.

12. Überwachungsgehäusesystem nach Anspruch 10, wobei:
a) Flansche auf der zweiten Kühlkörperhalterung (101) angeschrägt sind, um gegen einen Eckwinkel an der ersten Kühlkörperhalterung (102) zu passen, um besser in Position gesichert werden und besser Wärme übertragen zu können;
b) eine Kühlkörperhalterung (101, 102) an einer anderen Kühlkörperhalterung (101, 102) mit Schrauben gesichert ist, die eine Seitenfläche von einer der Kühlkörperhalterungen (101, 102) durchlaufen und in ein Aufnahmemanschette auf der anderen Kühlkörperhalterung (101, 102) gelangen, wodurch Flansche auf einer Kühlkörperhalterung (101, 102) in Kontakt mit einem Abschnitt der anderen Kühlkörperhalterung (101, 102) gezogen werden, um die laterale Spannung für weiter verbesserte Wärmeübertragung an das Kühlkörpergehäuse (100) zu erhöhen sowie außerdem die Kühlkörperhalterungen (101, 102) miteinander zu verriegeln;
c) komplementäre Rillen beziehungsweise Schienen auf den Kühlkörperhalterungen (101, 102) und Wänden des Kühlkörpergehäuses (100) effiziente Ausrichtung der Kühlkörperhalterungen (101, 102) innerhalb des Kühlkörpergehäuses (100) bereitstellen, wodurch diese am Verkanten oder Steckenbleiben während des Einführens oder Entfernens aus dem Kühlkörpergehäuse (100) gehindert werden;
d) eine hintere Platte das Kühlkörpergehäuse (100) versiegelt und jeweilige Kühlkörperhalterungen (101, 102) in Position sichert, um Komponenten die auf den Kühlkörperhalterungen (101, 102) montiert sind, an einem gewünschten Ort innerhalb des Kühlkörpergehäuses (100) zu versiegeln und zu sichern.

## Revendications

1. Système de boîtier de surveillance comprenant deux supports dissipateurs thermiques (101, 102) ayant des composants montés par-dessus qui bénéficient d'une dissipation de la chaleur, les supports dissipateurs thermiques (101, 102) ayant des collerettes qui peuvent être comprimées pour insertion dans un boîtier dissipateur thermique (100) et qui peuvent être relâchées pour appuyer contre des parties internes du boîtier dissipateur thermique (100), un des deux supports dissipateurs thermiques (101, 102) étant glissé jusqu'à une butée sur une paroi du boîtier dissipateur thermique (100) et positionnant ainsi les composants montés sur ledit support dissipateur thermique (101, 102) à un emplacement souhaité à l'intérieur du boîtier dissipateur thermique (100), **caractérisé en ce que** les supports dissipateurs thermiques (101, 102) sont des supports en C avec les collerettes compressibles élastiques perpendiculaires à une partie de panneau de contact central du support en C, **en ce qu'**un dispositif d'éclairage est monté sur un premier support dissipateur thermique (101) comme un des deux supports dissipateurs thermiques (101, 102), et **en ce qu'**un composant d'alimentation est monté sur un deuxième support dissipateur thermique (101) comme un autre des deux supports dissipateurs thermiques (101, 102).

2. Système de boîtier de surveillance de la revendication 1, dans lequel une caméra (105) et le dispositif d'éclairage sont montés sur le premier support dissipateur thermique (102), pour offrir un alignement optique facile et sûr.

3. Système de boîtier de surveillance de la revendication 2, dans lequel les collerettes sur le premier support dissipateur thermique (102) sont dimensionnées de telle sorte qu'une partie des collerettes jouxtant une partie centrale du deuxième support dissipateur thermique (101) butent contre des parties d'extrémité des collerettes sur le premier support dissipateur thermique (102) quand les supports dissipateurs thermiques (101, 102) sont glissés jusqu'à une butée sur une paroi adjacente à une extrémité du boîtier dissipateur thermique (100) et positionnent ainsi des composants montés sur les supports dissipateurs thermiques respectifs (101, 102) à un emplacement souhaité à l'intérieur du boîtier dissipateur thermique (100).

4. Système de boîtier de surveillance de la revendication 3, dans lequel un cadre avant de boîtier avec une fenêtre pour dispositif d'éclairage et caméra s'ajuste sur la caméra (105) et le dispositif d'éclairage montés sur le premier support dissipateur thermique (102) qui a été glissé dans le boîtier dissipateur thermique (100).

5. Système de boîtier de surveillance de la revendication 1, dans lequel les collerettes, une fois relâchées, butent contre et exercent une pression sur des parties de parois latérales internes du boîtier dissipateur thermique (100).

6. Système de boîtier de surveillance de la revendication 1, dans lequel les collerettes sur le deuxième support dissipateur thermique (101) sont biseautées pour s'ajuster contre un angle sur le premier support dissipateur thermique (102) pour mieux assurer la position et le transfert de chaleur.

7. Système de boîtier de surveillance de la revendication 1, dans lequel un support dissipateur thermique (101, 102) est fixé à un autre support dissipateur thermique (101, 102) avec des vis qui passent à travers une partie de face d'un des supports dissipateurs thermiques (101, 102) et à l'intérieur d'un collet de réception sur l'autre support dissipateur thermique (101, 102), les collerettes sur un support dissipateur thermique (101, 102) étant tirées pour venir en contact avec une partie de l'autre support dissipateur thermique (101, 102) afin d'augmenter la tension latérale pour un transfert de chaleur encore amélioré au boîtier dissipateur thermique (100), en plus du verrouillage des supports dissipateurs thermiques (101, 102) l'un avec l'autre.

8. Système de boîtier de surveillance de la revendication 1, dans lequel des rainures et sillons complémentaires, respectivement sur les supports dissipateurs thermiques (101, 102) et des parois du boîtier dissipateur thermique (100), offrent un alignement efficace des supports dissipateurs thermiques (101, 102) à l'intérieur du boîtier dissipateur thermique (100), les empêchant de pencher ou d'être coincés pendant l'insertion ou le retrait du boîtier dissipateur thermique (100).

9. Système de boîtier de surveillance de la revendication 1, dans lequel un panneau arrière scelle le boîtier dissipateur thermique (100) et fixe en position des supports dissipateurs thermiques respectifs (101, 102), afin de sceller et fixer des composants montés sur les supports dissipateurs thermiques (101, 102) à un emplacement souhaité à l'intérieur du boîtier dissipateur thermique (100).

10. Système de boîtier de surveillance de la revendication 1, dans lequel :
a) le support dissipateur thermique (101, 102) comprend une partie centrale de dissipateur thermique sur laquelle est montée une carte de circuit pour des composants ;
b) le premier support dissipateur thermique (102) est glissé jusqu'à une butée sur une paroi adjacente à une extrémité du boîtier dissipateur thermique (100) et positionne ainsi des composants montés sur le premier support dissipateur thermique (102) à un emplacement souhaité à l'intérieur du boîtier dissipateur thermique (100) ;
c) les collerettes sur le premier support dissipateur thermique (102) sont dimensionnées de telle sorte qu'une partie des collerettes jouxtant une partie centrale du deuxième support dissipateur thermique (101) butent contre des parties d'extrémité des collerettes sur le premier support dissipateur thermique (102) quand les supports dissipateurs thermiques (101, 102) sont glissés jusqu'à une butée sur une paroi adjacente à une extrémité du boîtier dissipateur thermique (100) et positionnent ainsi des composants montés sur les supports dissipateurs thermiques respectifs (101, 102) à un emplacement souhaité à l'intérieur du boîtier dissipateur thermique (100) ;
d) un cadre avant de boîtier avec fenêtre pour dispositif d'éclairage et caméra s'ajuste sur une caméra (105) et le dispositif d'éclairage montés sur le premier support dissipateur thermique (102) qui a été glissé dans le boîtier dissipateur thermique (100) ;
e) les collerettes, une fois relâchées, butent contre et exercent une pression sur des parties de parois latérales internes du boîtier dissipateur thermique (100) ;
f) un dessus du boîtier dissipateur thermique (100) a des nervures pour une surface accrue pour dissiper plus de chaleur depuis l'intérieur du boîtier dissipateur thermique (100).

11. Système de boîtier de surveillance de la revendication 1, dans lequel :
a) les collerettes sur le deuxième support dissipateur thermique (101) sont biseautées pour s'ajuster contre un angle sur le premier support dissipateur thermique (102) pour mieux assurer la position et le transfert de chaleur ;
b) un support dissipateur thermique (101, 102) est fixé à un autre support dissipateur thermique (101, 102) avec des vis qui passent à travers une partie de face d'un des supports dissipateurs thermiques (101, 102) et à l'intérieur d'un collet de réception sur l'autre support dissipateur thermique (101, 102), les collerettes sur un support dissipateur thermique (101, 102) étant tirées pour venir en contact avec une partie de l'autre support dissipateur thermique (101, 102) afin d'augmenter la tension latérale pour un transfert de chaleur encore amélioré au boîtier dissipateur thermique (100), en plus du verrouillage des supports dissipateurs thermiques (101, 102) l'un avec l'autre ;
c) des rainures et sillons complémentaires, respectivement sur les supports dissipateurs thermiques (101, 102) et des parois du boîtier dissipateur thermique (100), offrent un alignement efficace des supports dissipateurs thermiques (101, 102) à l'intérieur du boîtier dissipateur thermique (100), les empêchant de pencher ou d'être coincés pendant l'insertion ou le retrait du boîtier dissipateur thermique (100).

12. Système de boîtier de surveillance de la revendication 10, dans lequel :
a) les collerettes sur le deuxième support dissipateur thermique (101) sont biseautées pour s'ajuster contre un angle sur le premier support dissipateur thermique (102) pour mieux assurer la position et le transfert de chaleur ;
b) un support dissipateur thermique (101, 102) est fixé à un autre support dissipateur thermique (101, 102) avec des vis qui passent à travers une partie de face d'un des supports dissipateurs thermiques (101, 102) et à l'intérieur d'un collet de réception sur l'autre support dissipateur thermique (101, 102), les collerettes sur un support dissipateur thermique (101, 102) étant tirées pour venir en contact avec une partie de l'autre support dissipateur thermique (101, 102) afin d'augmenter la tension latérale pour un transfert de chaleur encore amélioré au boîtier dissipateur thermique (100), en plus du verrouillage des supports dissipateurs thermiques (101, 102) l'un avec l'autre ;
c) des rainures et sillons complémentaires, respectivement sur les supports dissipateurs thermiques (101, 102) et des parois du boîtier dissipateur thermique (100), offrent un alignement efficace des supports dissipateurs thermiques (101, 102) à l'intérieur du boîtier dissipateur thermique (100), les empêchant de pencher ou d'être coincés pendant l'insertion ou le retrait du boîtier dissipateur thermique (100) ;
d) un panneau arrière scelle le boîtier dissipateur thermique (100) et fixe en position des supports dissipateurs thermiques respectifs (101, 102), afin de sceller et fixer des composants montés sur les supports dissipateurs thermiques (101, 102) à un emplacement souhaité à l'intérieur du boîtier dissipateur thermique (100) .
